(19) Europäisches Patentamt
European Patent Office
Office européen des brevets

(11) EP 3 403 954 A1

(12) EUROPEAN PATENT APPLICATION
published in accordance with Art. 153(4) EPC

(43) Date of publication:
21.11.2018 Bulletin 2018/47

(51) Int Cl.:
B65G 49/07 (2006.01)    H01L 21/677 (2006.01)

(21) Application number: 17738515.0

(22) Date of filing: 13.01.2017

(86) International application number:
PCT/JP2017/000955

(87) International publication number:
WO 2017/122763 (20.07.2017 Gazette 2017/29)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 15.01.2016 JP 2016006491
15.01.2016 JP 2016006493

(71) Applicant: Nano-Tem Co., Ltd.
Nagaoka-shi, Niigata 940-0021 (JP)

(72) Inventors:
• TAKATA, Atsushi
Nagaoka-shi
Niigata 940-0045 (JP)
• TAKATSU, Masakazu
Mitsuke-shi
Niigata 954-0058 (JP)
• ISHIZAKI, Kozo
Nagaoka-shi
Niigata 940-0053 (JP)
• ONODERA, Norio
Nagaoka-shi
Niigata 940-0021 (JP)

(74) Representative: Prüfer & Partner mbB
Patentanwälte · Rechtsanwälte
Sohnckestraße 12
81479 München (DE)

(54) **CONTACTLESS CARRIER DEVICE AND CONTACTLESS CARRIER SYSTEM**

(57) This invention is to provide a noncontact conveying apparatus and a noncontact conveying system, which can move an object from a conveying path to a predetermined position without using another device, and can convey the object in a noncontact manner without causing the object to fall down even if the conveying path is inclined or faces downwardly. The system includes a holding device 11 for holding an object 1 in a noncontact manner and a moving device 10 for moving the holding device 11. The holding device 11 includes a levitating device 7 for levitating the object 1 and an attracting device for attracting the object. The levitating device 7 includes a conveying plate 2 made of a porous material having a large number of pores, a compressor 6 for sending gas to the pores of the conveying plate and ejecting the gas from the pores towards the object. The moving device 10 is constituted by the magnetic material 8 and the magnet 9 for moving the object in a noncontact manner while attracting the object towards the conveying plate.

[Fig. 2]

EP 3 403 954 A1

## Description

Technical Field

The present invention relates to a noncontact conveying apparatus and a noncontact conveying system for conveying an object which may be a solid flat plate such as a wafer, a printed wiring board, a polymer film, a metal or the like, or an object having a flat surface on its one side, in a manner of being levitated away from a conveying path.

Background Art

Conventionally, as a wafer conveying apparatus, there is known an apparatus in which by controlling the flow rate of a gas supplied into the conveying chamber using a flow controller, and by making a flow of the gas flowing into a gap between a wafer and a conveying plate into a molecular flow or a transition flow region, it is possible to keep the conveying chamber at a high degree of vacuum to convey the wafer, and to allow the conveying apparatus to be directly connected to various vacuum processing devices without a buffer chamber (see, for example, Patent Document 1).
Further, there is known a porous air levitating/conveying travel passage in which a nonmagnetic member having a thickness smaller than that of porous materials on both adjacent sides is provided at the central portion of air levitating travel surface made of a porous material, and a device is provided on the backside of the nonmagnetic member for magnetically driving an air levitating/conveying carrier on which a magnet is disposed (see, for example, Patent Document 2).
In addition, there is known an air slide device composed of a guide member, a slider and an inner moving body, in which the slider is supported in a noncontact manner by a static pressure caused by a blowing air, and the slider is moved by the magnetic attraction force with the movement of the inner moving body on which a magnet is disposed (see, for example, Patent Document 3).
Moreover, there is known a small-size electrostatic levitating/conveying apparatus in which an electrical charge elimination signal generator for generating an electrical charge elimination signal for use in applying an alternating electric field to electrostatic levitation electrodes is provided at the front stage of the levitating voltage generator, so that it is possible to exactly eliminate static electricity on the glass substrate, with no trash or dust being attached thereon (see, for example, Patent Document 4).

Citation List

Patent Document

Patent Document 1: Japanese Unexamined Patent Application Publication No. 2001-176950
Patent Document 2: Utility Model Registration No. 3159137
Patent Document 3: Japanese Unexamined Patent Application Publication No. 5-238546
Patent Document 4: Japanese Unexamined Patent Application Publication No. 2000-25948

Summary of Invention

Technical Problems

However, in a conventional noncontact conveying apparatus, even if an object can be conveyed, another device is needed to move the object from a conveying path to a predetermined place.
Also, when the conveying path is tilted and three-dimensionally changes in its position, the object being conveyed will fall down due to its gravity.
The present invention has been made in view of the above circumstances, and it is an object of the present invention to provide a noncontact conveying apparatus and a noncontact conveying system, which can move an object from a conveying path to a predetermined place without using another device, and can convey the object in a noncontact manner without causing the object to drop down even if the conveying path is tilted or faces down.

Solution to the Problems

The present invention provides a noncontact conveying apparatus for conveying an object in a noncontact manner, the conveying apparatus comprising:

a holding device for holding the object in a noncontact manner; and
a moving device for moving the holding device;
wherein:

the holding device includes: a levitating device for levitating the object being conveyed; and an attracting device for attracting the object;
the levitating device has : a holding member formed of porous material having a plurality of pores; and gas delivery means for sending gas to the pores of holding member, and ejecting the gas from the pores towards the object being conveyed;
the attracting device is attached to the moving device in a manner such that the object is moved by moving the moving device .

Preferably, the holding member of the levitating device forms a fixed conveying path, the moving device is disposed on a side opposite to the object on the conveying path, and also serves as the attracting device for moving the object while attracting the object.

In the present invention, the conveying plate consists of porous material having a plurality of pores and thus forms a conveying path. A gas is sent by gas supply means to the pores of the conveying plate. The gas is then ejected from the pores towards the obj ect so as to levitate the obj ect from the conveying path. The attracting device is used to attract the object towards the holding member, so that the object is kept in a state where the obj ect is separated a predetermined distance from the holding member. In this way, the holding member holding the object in a noncontact manner is moved by the moving device to a desired place.

Therefore, even when the conveying plate is inclined or faces down, the holding member can convey the object in a noncontact manner without causing the inclined object to fall down.

Also, if two conveying plates are installed in parallel to the conveying direction and arranged to be overlapped with one conveying plate being upside down, when the obj ect being conveyed reaches the overlapped portion, the object can be moved to the upper conveying plate by changing over the moving device. When the object is moved to a desired position on the upper conveying plate, the moving device is stopped. At this time, since the object will fall down due to its gravity, it is possible to move the object to a predetermined place from the conveying plate serving as the conveying path.

In the above-described configuration of the present invention, it is preferable that the attracting device uses an attraction force of a magnet or electrostatic chuck electrodes.

In this way, the separated obj ect can be precisely positioned by forming a balance between the attractive force of the magnet or the electrostatic chuck electrodes and the gas pressure, so that the object can be accurately moved from a predetermined position to a desired position.

Further, in the above-described configuration of the present invention, the attracting device uses an attractive force of electrostatic chuck electrodes, the electrostatic chuck electrodes are disposed on a side opposite to the gas ejecting pores on the conveying path, and a plurality of the electrostatic chuck electrodes are arranged at a predetermined interval in a direction intersecting the conveying direction.

Moreover, the noncontact conveying apparatus further includes a control device, which is so configured that when an object is moved in the conveying direction, the object is moved by controlling a phase shift of a plurality of the electrostatic chuck electrodes and a phase shift of induced electrical charges generated in the object.

Besides, in the above-described configuration of the present invention,
the conveying path is arranged horizontally and linearly;
the moving device is disposed at either end in the conveying direction of the conveying path;
the attracting device levitates the object in a noncontact manner by utilizing the gravity of the object and the levitating device.

In addition, the noncontact conveying apparatus further includes a control device, which is so configured that when the object placed at one end of the conveying path is moved to the other end, the moving device disposed at the one end moves the object until the object reaches a predetermined speed, when the object speed reaches the predetermined speed, one of the moving devices is stopped, the object to be conveyed is moved by an obtained inertial force, and when the object reaches the other end, the other moving device is operated to stop the object.

Further, in the above-described configuration of the present invention, the holding member may be arranged at an angle with respect to a horizontal plane or a vertical plane.

In this way, it is possible to perform a conveyance in various directions . Moreover, it is also possible to use the work space three-dimensionally.

Besides, a noncontact conveying system is provided in which the conveying path or the holding member of one noncontact conveying apparatus and the conveying path or the holding member of the other noncontact conveying apparatus, positioned adj acent to each other, are orientated to face one another, and arranged to be partially and mutually overlapped.

In the present invention, by controlling the timings of turning-on and turning-off of the operations of one noncontact conveying apparatus and the other noncontact conveying apparatus adjacent to each other, it is possible to convey the object in a manner of being levitated from the conveying path in one and the other noncontact conveying apparatuses. Further, by changing the mutually adjacent conveying paths into different conveying directions, it is possible to change the conveying direction of the object being conveyed.

Effects of the Invention

According to the present invention, noncontact conveying apparatus and a noncontact conveying system can thus be provided, can convey an object from the conveying path to a predetermined place without using another device, and can convey the object in a noncontact manner without dropping it down even if the conveying path is inclined or faces down.

Brief Description of Drawings

Fig. 1 is a plan view showing a noncontact conveying apparatus according to the first embodiment of the present invention.

Fig. 2 is a cross-sectional view taken along line A - A in Fig. 1.

Fig. 3 is a cross-sectional view showing a noncontact conveying apparatus according to the second embodiment of the present invention.

Fig. 4 is a plan view showing a noncontact conveying apparatus according to the third embodiment of the present invention.

Fig. 5 is a cross-sectional view taken along line B - B in Fig. 4.

Fig. 6 is a plan view explaining a noncontact conveying method using a noncontact conveying apparatus according to the third embodiment of the present invention.

Fig. 7 is a cross-sectional view taken along line C - C in Fig. 6.

Fig. 8 is a cross-sectional view showing a noncontact conveying system according to the fourth embodiment of the present invention.

Fig. 9 is a cross-sectional view showing a noncontact conveying system according to the fifth embodiment of the present invention.

Fig. 10 is a plan view showing a noncontact conveying apparatus according to the sixth embodiment of the present invention.

Fig. 11 is a cross-sectional view taken along line A - A in Fig. 10.

Fig. 12 is a plan view showing a noncontact conveying apparatus according to the seventh embodiment of the present invention.

Fig. 13 is a cross-sectional view taken along line B - B in Fig. 12.

Fig. 14 is a graph showing a relationship between an area ratio $\alpha$ and a conductance ratio $\beta$ of an object being conveyed in the present invention.

Description of Embodiments

Embodiments of the present invention will be described below with reference to the drawings.

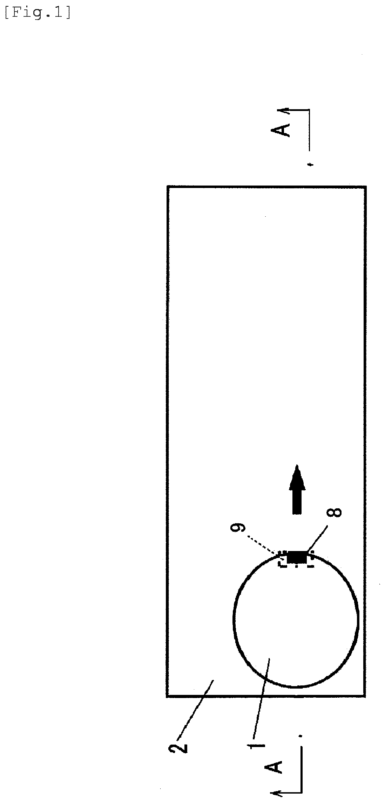

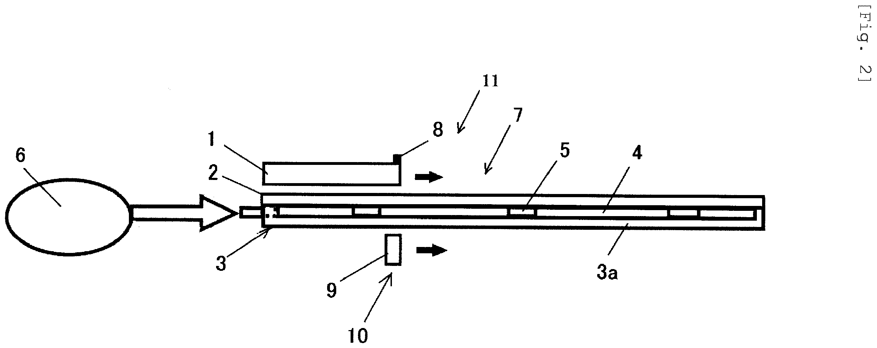

First, a noncontact conveying apparatus according to the first embodiment of the present invention will be described with reference to Fig. 1 and Fig 2.

As shown in these figures, an object 1 to be conveyed moves in parallel to the surface of the conveying plate 2 serving as conveying path, while the object 1 itself being levitated from the conveying plate 2.

The object 1 to be conveyed is, for example, a flat plate such as a wafer or a polymer film. Preferably, the object 1 to be conveyed is a flat member at least one surface of which is flat surface (a surface facing the conveying plate 2).

The conveying plate 2 is made of a porous material having a large number of pores. The pores are preferably those having a large head loss (a conductance ratio to be described below is small) when gas passes through these pores. The material of the conveying plate 2 varies depending on a moving device to be described later, but insulators such as ceramics and plastics are preferable in the case of using an electrostatic force. Further, in the case of using a magnetic force or the like, it is preferable that the conveying plate 2 be formed of a nonmagnetic material, such as porous ceramics and the like. Here, the conveying plate 2 is formed into a flat plate and extends in the shape of a belt.

A lid member 3a made of a nonmagnetic material is attached under the conveying plate 2, thus forming a pressurizing chamber 4 sealed between the conveying plate 2 and the lid member 3a. The lid member 3a is formed into a flat plate and extends in parallel to the conveying plate 2. The lid member 3a is preferably an insulator such as ceramics or plastics when an electrostatic force is used as the moving device, and it is preferably composed of a nonmagnetic material when using a magnetic force or the like. The lid member 3a may be made of porous ceramics like the conveying plate 2. However, in this case, the pores are sealed so as to prevent the gas from leaking to the outside.

Pressurized gas is fed from the compressor (gas delivery means) 6 to the pressurizing chamber 4 between the conveying plate 2 and the lidmember 3a. In this way, the gas passes through the pores of the conveying plate 2 and oozes out from the surface of the conveying plate 2. In this way, the object 1 is levitated from the conveying plate 2 by the seeping gas.

In this way, a levitating device 7 is thus constituted by the conveying plate 2 and the compressor 6.

As described above, regarding a large number of pores of the conveying plate 2, if a head loss through which gas of the pores passes is large, even when the object 1 moves while being levitated on a part of the surface of the conveying plate 2, it is still possible to ensure an exact movement of the object 1. For example, when performing a noncontact conveyance on the conveying plate 2 having a large area along various trajectories, or when conveying a small object 1 in a noncontact manner, it will be effective to increase a resistance when the gas of the pores passes through. On the other hand, if the head loss through which the gas of the pores passes is not large, the gas will vigorously blow out from the pores of the conveying plate 2 where there is no object 1 being conveyed, resulting in a weak eruption of the gas in an area having an object 1, hence decreasing a desired repulsive force.

A magnetic member 8 made of a magnetic material such as iron or the like is attached to the front end of the object1 in the conveying direction (indicated by an arrow in Fig. 2) by clipping or fixing means such as an adhesive. On the other hand, under the lid member 3a, a magnet 9 made of a permanent magnet, an electromagnet or the like is disposed at a position corresponding to the magnetic member 8. The magnet 9 is disposed slightly away from the lid member 3a and is configured to move in parallel to the surface of the conveying plate 2 by virtue of moving means (not shown). Here, it should be noted that the magnet 9 may move in contact with the lid member 3a. At this time, it is preferable that the back surface of the lid member 3a is parallel to the surface of the conveying plate 2.

In this way, a moving device 10 is thus formed by the magnetic member 8 and the magnet 9. On the other hand, an attachment position of the magnetic member 8 does not have to be at the front end of an object being conveyed.

Next, an explanation will be given to describe a conveying method for conveying an object 1 by using a noncontact conveying apparatus described above.

First, a gas pressurized by the compressor 6 is fed into the pressurizing chamber 4 between the conveying plate 2 and the lid member 3a, and this gas is then ejected from the surface of the conveying plate 2 through the pores of the conveying plate 2.

Next, the object 1 is placed at a predetermined position on the conveying plate 2. In this way, the object 1 is disposed in a state of being levitated from the conveying plate 2.

Subsequently, the magnet 9 is disposed at a position corresponding to the magnetic member 8 on the object 1 being conveyed. In this way, the magnetic member 8 is attracted by the magnetic force of the magnet 9, so that the object 1 is fixed in position. Here, it should be noted that it is also possible to place the object 1 on the conveying plate 2 after the magnet 9 is placed at a predetermined position. In addition, it is further possible to at first place the object 1 on the conveying plate 2 and then cause the gas to be ejected from the surface of the conveying plate 2, so that the object 1 is levitated from the conveying path.

Next, the magnet 9 is moved to a position to which the object 1 is to be moved. Then, due to an attracting force based on the magnetic force between the magnet 9 and the magnetic member 8, the object 1 moves in parallel to the surface of the conveying plate 2 while following the movement of the magnet 9 and being kept levitated.

Then, the feeding of gas from the compressor 6 is stopped, or gas is removed from the pressurizing chamber 4 to lower the air pressure in the pressurizing chamber 4. In this way, the object 1 can be placed at a predetermined position on the conveying plate 2. This position can be precisely controlled by adjusting the position of the magnet 9.

Next, the magnet 9 is separated from the lid member 3a, so that the object 1 is released from the attracting force based on the magnetic force. If the magnet 9 is an electromagnet, the magnet 9 can be kept as it is simply by demagnetizing the electromagnet.

In the noncontact conveying apparatus thus configured, since the object 1, which is levitated by the gas being ejected from the surface of the conveying plate 2, is attracted by the magnetic force formed between the magnet 9 and the magnetic member 8 towards the conveying plate 2, even if the conveying plate 2 is installed at an angle with respect to a horizontal plane or a vertical plane, it is still possible to convey the object 1 while being levitated from the conveying path without falling down. Thus, it is possible to dispose the conveying plate 2 to make it tilted with respect to the ground surface, or cause the surface of the conveying plate 2 to face the ground surface. Further, if the conveying plate 2 is installed in parallel to the conveying direction but upside down, when the conveying plate 2 arrives at a purpose position of the conveying plate 2, an action of the attraction force of the lower conveying plate moving device is stopped, and at the same time the movement of the upper conveying plate moving device is actuated. As a result, the object 1 is conveyed to a predetermined position by the upper conveying plate . In this way, the object 1 will fall down due to the gravity if the upper conveying plate moving device is stopped. Thus, it is possible to convey the object 1 from the conveying plate 2 to a predetermined place without using another device.

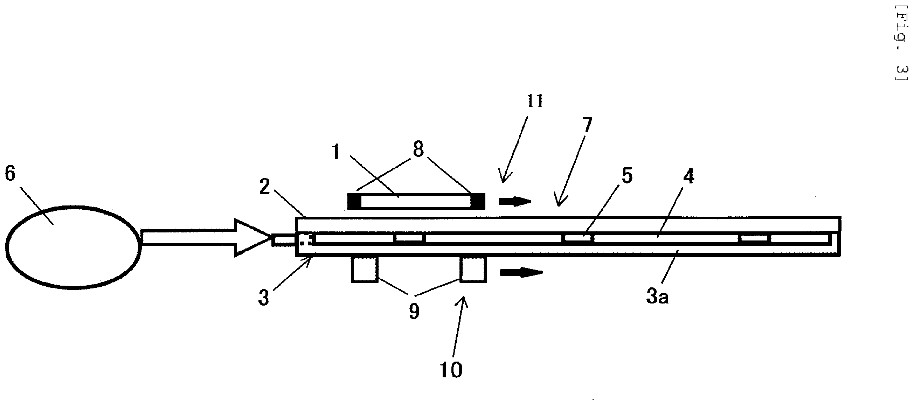

Next, an explanation will be given to describe a noncontact conveying apparatus according to the second embodiment of the present invention, with reference to Fig. 3.

As shown in the figure, in this embodiment, magnetic members 8, 8 are respectively attached to the front and rear ends of the object 1 in the conveying direction, while magnets 9, 9 are disposed respectively at positions corresponding to the magnetic members 8, 8, with other configurations being the same as those in the first embodiment.

According to this embodiment, even if the conveying plate 2 is in a tilted position or the like, it is still possible to inhibit the object 1 from rotating.

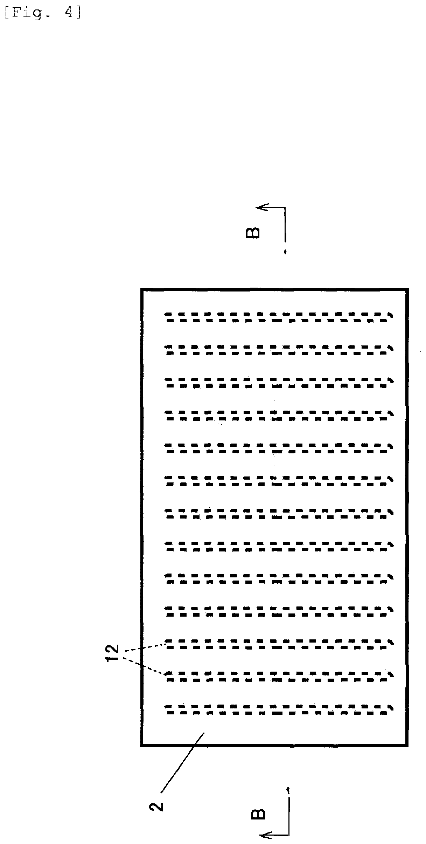

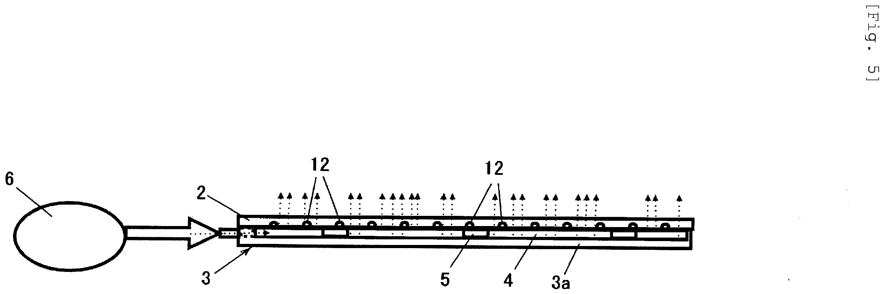

Next, an explanation will be given to describe a noncontact conveying apparatus according to the third embodiment of the present invention, with reference to Figs. 4 and 5.

As shown in these figures, in the present embodiment, rather than using the magnet 9 employed in the first embodiment, a large number of electrostatic chuck electrodes 12 are buried in a belt-like conveying plate 2 extending in the conveying direction. These electrostatic chuck electrodes 12 are arranged to extend in a direction orthogonal to the conveying direction and are disposed along a plurality of lines arranged parallel to each other at a predetermined interval. When these electrostatic chuck electrodes 12 are energized, the object 1 being conveyed is attracted by the attracting force generated between the electrostatic chuck electrodes 12 and the object 1.

In Fig. 5, the broken arrows indicate the flow of the gas. In fact, a control device (not shown) is provided, such that when the obj ect 1 to be conveyed is moved in the conveying direction, if positive and negative potentials are alternately applied to the plurality of electrostatic chuck electrodes 12, a potential opposite to the electrostatic chuck electrodes 12 will be generated in the object 1, thereby controlling the phase of a current flowing through the chuck electrodes 12.

Although this embodiment does not involve a magnetic member 8 for object 1 as in the first embodiment, the remaining configurations are the same as those in the first embodiment.

In this embodiment, since the electrostatic chuck electrodes 12 are employed instead of the magnet 9, it is possible to set a short distance between the object 1 and the surface of the electrostatic chuck electrodes 12.

A distance between the surface of the electrostatic chuck electrodes 12 and the surface of the conveying plate 2 is preferably 0.001 to 5.0 mm, more preferably 0.001 to 3.0 mm, further preferably 0.001 to 2.0 mm. The thickness of the conveying plate 2 is preferably 2.0 to 25.0 mm, more preferably 2.0 to 20.0 mm, and further preferably 2.0 to 10.0 mm.

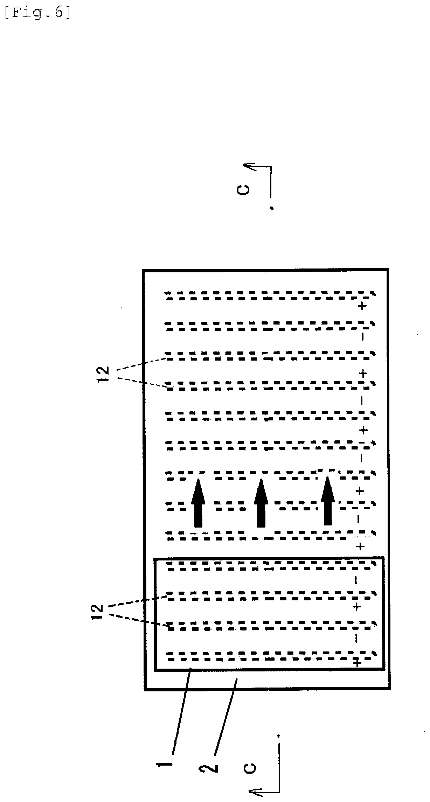

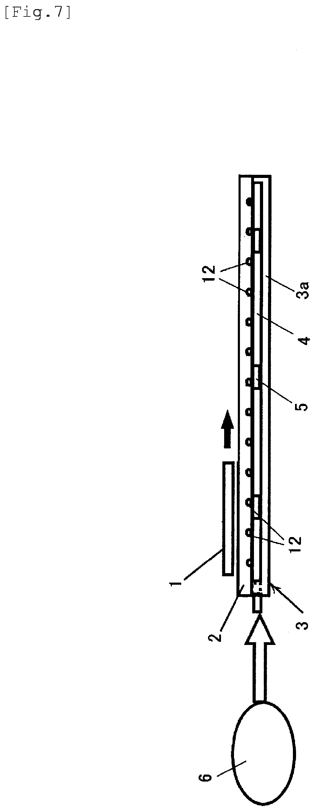

Next, with reference to Figs. 6 and 7, an explanation will be given to describe a noncontact conveying method using a noncontact conveying apparatus formed according to the third embodiment of the present invention.

First, a gas pressurized by the compressor 6 is fed into the pressurizing chamber 4 between the conveying plate 2 and the lid member 3a, so that this gas is ejected from the surface of the conveying plate 2 through the pores of the conveying plate 2.

Next, an obj ect 1 having a predetermined shape (a rectangular plate in this example) is placed at a predetermined position on the conveying plate 2. In this way, the object 1 stops at a predetermined position in a state where it is levitated from the conveying plate 2.

Next, the electrostatic chuck electrodes 12 (in this example, four rows of electrostatic chuck electrodes 12) located on the lower side on which the object 1 is placed is energized and alternately applied with positive and negative potentials. As a result, a potential opposite to that of the electrostatic chuck electrodes 12 is generated in the object 1 so that the object 1 is attracted, thus fixing the object 1 in position. On the other hand, it is also possible to at first energize the electrostatic chuck electrodes 12 (in this example, the four rows of electrostatic chuck electrodes 12) located on the lower side where the object 1 is placed, and then the object 1 is placed onto the conveying plate 2. Further, it is also possible to at first place the object 1 on the conveying plate 2, and gas is then ejected from the surface of the conveying plate 2, so that the object 1 is levitated from the conveying path.

Here, there is provided a control device (not shown) so configured that when the object 1 is moved in the conveying direction, the control device will control the phase of the current flowing through a plurality of electrostatic chuck electrodes 12, so as to move the object 1 by making use of a phase shift of an induced potential generated in the object 1. In this way, the control device is used to sequentially move the object 1 in the conveying direction while being levitated.

Then, the feeding of gas from the compressor 6 is stopped, or gas is removed from the pressurizing chamber 4, so as to lower the air pressure in the pressurizing chamber 4. In this way, the object 1 is placed at a predetermined position on the conveying plate 2. This position can be precisely controlled by adjusting the positions of the electrostatic chuck electrodes 12. Next, the power supply to the electrostatic chuck electrodes 12 is stopped. As a result, the object 1 is released from the attracting force based on the electrostatic chuck electrodes 12.

On the other hand, if the control device is provided which can perform the following operations, it is possible to perform a part of noncontact conveyance by virtue of an inertial force. Namely, when the conveying plate 2 is horizontally and linearly arranged, the moving devices are disposed at both end portions of the conveying plate 1 in the conveying direction, and when an object 1 placed at one end portion is moved towards the other end portion, the object 1 will be moved until it reaches a predetermined speed by virtue of the moving device disposed at the one end portion. When the object 1 reaches the predetermined speed, one moving device at one end portion is stopped, while the object 1 is caused to move still further by virtue of an inertial force obtained at this moment. When the object 1 arrives at the other end portion, the moving device at the other end portion is operated to stop the object 1.

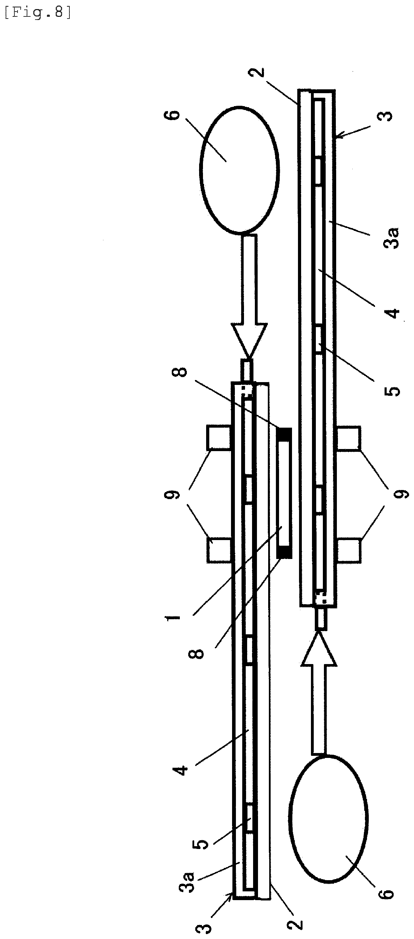

Next, an explanation will be given to describe a noncontact conveying system according to the fourth embodiment of the present invention, with reference to Fig. 8.

This embodiment involves a plurality of noncontact conveying apparatus (in this example, two apparatus) formed according to the above-described second embodiment. Further, one adjacent noncontact conveying apparatus is disposed upside down with respect to the other noncontact conveying apparatus. The conveying plates 2, 2 are arranged in parallel to each other. In addition, one noncontact conveying apparatus and the other noncontact conveying apparatus are installed such that the two conveying plates 2, 2 partially overlap with each other in the conveying direction.

In this way, by controlling (matching) the timings of turning-on and turning-off for the operations of one noncontact conveying apparatus and the other noncontact conveying apparatus adjacent to each other, it is possible to use one noncontact conveying apparatus to convey an object 1 from one end portion of the conveying plate 2 to the other end portion thereof, and in such a state without being changed, to use the other noncontact conveying apparatus to convey the object 1 from one end portion of the other conveying plate 2 to the other end portion thereof, At this time, the two mutually related conveying plates 2, 2 may be arranged in a straight line or may be arranged at an angle to each other.

Further, if one noncontact conveying apparatus with the conveying plate 2 facing down is made to be the last noncontact conveying apparatus during the noncontact conveyance, when an object 1 reaches a purpose position of the conveying plate 2, since the object 1 will fall down due to its gravity if the action of the attracting force of the moving device 10 is stopped, it is possible to move the object 1 from the conveying plate 2 to a predetermined place without using another device.

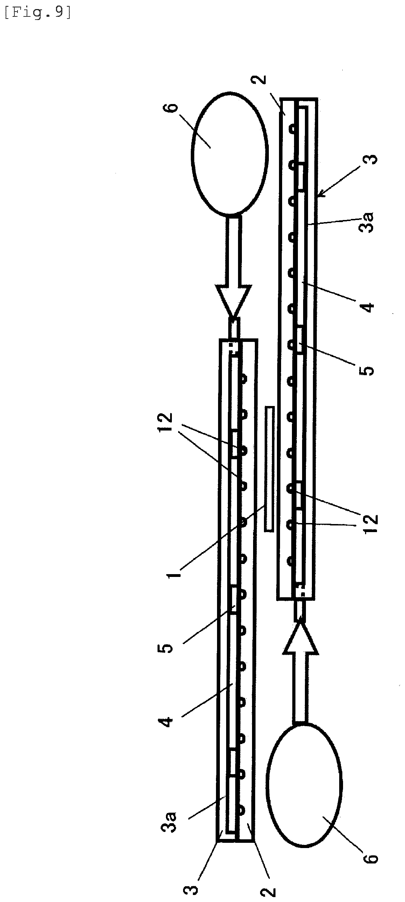

Next, an explanation will be given to describe a noncontact conveying system formed according to the fifth embodiment of the present invention, with reference to Fig. 9.

This embodiment involves a plurality of noncontact conveying apparatus (in this example, two apparatuses) formed according to the above third embodiment. In addition, one adjacent noncontact conveying apparatus is disposed upside down with respect to the other noncontact conveying apparatus. The conveying plates 2, 2 are arranged in parallel to each other. Further, one noncontact conveying apparatus and the other noncontact conveying apparatus are installed such that the conveying plates 2, 2 partially overlap with each other in the conveying direction.

In this way, it is possible to convey the object 1 in a way similar to the noncontact conveying system of the first embodiment.

Next, an explanation will be given to describe the conveying plate 2. Namely, the explanation will be on how to enable a conveying plate 2 to have a repulsive force equal to or greater than the gravity of the object 1 being conveyed, regardless of the size of the object 1.

Namely, when an object 1 to be conveyed 1 is placed on the conveying plate 2 in which the pressure of the pressurizing chamber 4 (hereinafter, referred to as "internal pressure") is P2, a differential pressure $\Delta P$ between the external pressure P1 (for example, an atmospheric pressure, or a vacuum in some cases) and the internal pressure P2 is received vertically at openings of the pores covered by the object 1 being conveyed.

That is, the object 1 receives a repulsive force F obtained by multiplying the sum total of the opening areas of all the pores covered with the object 1 by the differential pressure $\Delta P$.

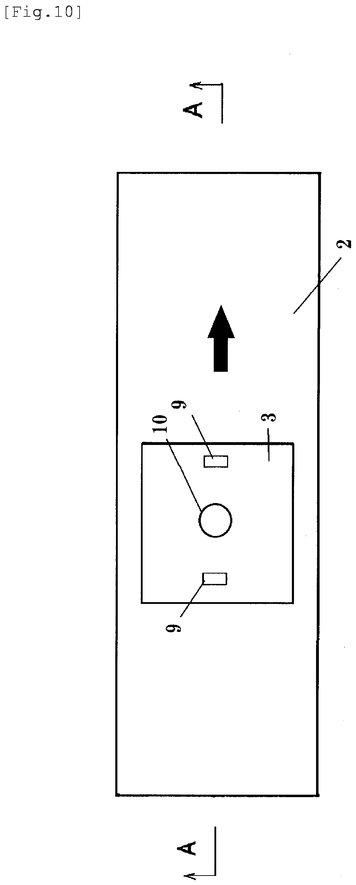

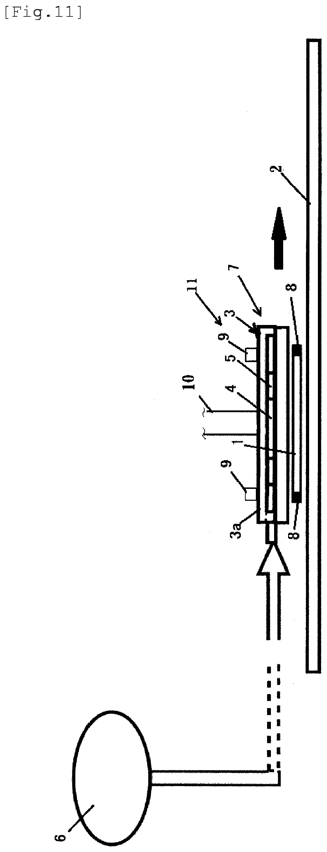

Next, an explanation will be given to describe a noncontact conveying apparatus formed according to the sixth embodiment of the present invention, with reference to Figs. 10 and 11.

In these figures, the object 1 moves in parallel to the surface of the conveying path 2 in a noncontact state over the conveying plate 2. The object 1 to be conveyed is, for example, a plate-shaped article such as a wafer, a printed wiring board, a polymer film, or a metal. It is preferable that an object 1 to be conveyed has a flat plate shape or at least one surface thereof (the surface facing a holding member 3 which is to be described later) is flat.

The holding member 3 of the noncontact conveying apparatus is formed of a porous material having a large number of pores. The pores are preferably those having a large head loss (a conductance ratio to be described later is small) when gas passes through these pores. A material forming the holding member 3 varies depending on a moving device to be described later, but it is preferable to use an insulator such as ceramics and plastics when an electrostatic force is to be used. When using a magnetic force or the like, it is preferable to form the holding member 3 using a nonmagnetic material such as porous ceramics or the like. Further, the holding member 3 is formed into a square flat plate.

A lid member 3a made of a nonmagnetic material is attached to the upper side of the holding member 3, thus forming a pressurizing chamber 4 hermetically sealed between the holding member 3 and the lid member 3a. The lid member 3a is in the form of a flat plate, extending in parallel to the holding member 3. The lid member 3a is preferably an insulator such as ceramics or plastics when an electrostatic force is used as an attracting device (which is to be described later), and it is preferably composed of a nonmagnetic material when using a magnetic force or the like. Like the holding member 3, the lid member 3a may be made of porous ceramics, but in this case, the pores are sealed so as not to allow the gas to leak to the outside.

A pressurized gas is sent out from the compressor (gas delivery means) 6 to the pressurizing chamber 4 between the holding member 3 and the lid member 3a, so that the gas passes through the pores of the holding member 3 and is ejected from the surface of the holding member 3. In this way, the object 1 is levitated (separated) from the holding member 3 by virtue of the gas being ejected.

Accordingly, a separating device 7 is thus constituted by the holding member 3 and the compressor 6.

Magnetic members 8, 8 made of a magnetic material such as iron are fixed to the front end portion and the rear end portion of the object 1 being conveyed in the traveling direction thereof (indicated by arrows in Figs. 10 and 11), by virtue of fastening means such as clips or an adhesive. On the other hand, on the upper side of the lid member 3a, magnets 9, 9 made of a permanent magnet, electromagnet or the like are arranged at positions corresponding to the respective magnetic members 8, 8.

By attracting the magnetic members 8, 8 and the magnets 9, 9 toward each other, the object 1 to be conveyed is drawn towards the holding member 3. However, it should be noted that the attachment positions of the magnetic members 8, 8 may be arbitrary points instead of the front end portion and the rear end portion of the object 1. Further, it is preferable to provide a plurality of attachment positions for the magnetic members 8, 8, thus making it possible to hold the center of gravity at one place or keep the center of gravity.

In this way, an attracting device is thus constituted by the magnetic members 8, 8 and the magnets 9, 9.

The object 1 is held in a noncontact manner by the holding member 3 at a position where a force produced by the separating device 7 for separating the object 1 from the holding member 3 and a force produced by the attracting device for attracting the object 1 towards the holding member 3 are in equilibrium.

In this way, a holding device 11 is thus constituted by the separating device 7 and the attracting device.

The object 1 held on the holding member 3 by the holding device 11 is adapted to be moved by the moving device 10 that moves the holding member 3.

For use as the moving device 10, it is usual to employ, for example, an arm or a manipulator or the like which is moved by an actuator. On the other hand, it is also possible to use other type of device, as long as it can move the holding device. In the present embodiment, the holding device 3 is moved by moving the moving device 10 fixed to the center portion of the outer surface of the lid member 3a, using an actuator employing a pressure such as hydraulic pressure or pneumatic pressure.

Next, an explanation will be given to describe a method for conveying the object 1, using the noncontact conveying apparatus configured as described above. First, an object 1 having a predetermined shape (a square plate in this example) is placed at a predetermined position on a conveying path 2. Then, a gas pressurized by the compressor 6 is fed into the pressurizing chamber 4 between the holding member 3 and the lid member 3a, so that the gas is ejected from the surface of the holding member 3 through the pores of the holding member 3.

Next, by moving the moving device 10, the holding member 3 is positioned to face the object 1. Then, the magnetic material 8 is attracted by the magnetic force of the magnet 9, while the object 1 is separated from the holding member 3 by the gas being ejected from the surface of the holding member 3. In this way, the object 1 is held on the holding member 3 in a noncontact manner, at a position where a force attracting the object 1 towards the holding member 3 and a force separating the object 1 from the holding member 3 become equal to each other, thereby arriving at an equilibrium.

Next, by moving the moving device 10, the holding member 3 is moved to a predetermined position.

Subsequently, if the magnet 9 is an electromagnet, it will be demagnetized. On the other hand, if the magnet is a permanent magnet, it will be moved away. In this way, the object 1 can be mounted on the conveying path 2.

Afterwards, by moving the moving device 10, the holding member 3 is separated from the object 1 or the air from the compressor is stopped.

When using the noncontact conveying apparatus configured as described above, the object 1 can be held by the holding member 3 in a noncontact manner, at a position where a force produced by the separating device 7 for separating the object 1 from the holding member 3 and a force produced by the attracting device for attracting the object towards the holding member 3 are in equilibrium. As a result, even if the holding member is positioned on the lower side or at an angle with respect to the horizontal plane, it is still possible to convey the object 1 along the conveying path 2 without being dropped down and without coming into contact with the conveying path.

In addition, by adjusting a force produced by the separating device 7 for separating the object 1 from the holding member 3 and a force produced by the attracting device for attracting the object 1 towards the holding member 3, it is possible to keep or place the object 1, thus rendering it possible to move the obj ect 1 to a predetermined place without using an additional device.

In the above-described embodiment, the object 1 is moved along the conveying path 2, but it is also possible to move the object 1 from a certain place to another place without going along the conveying path 2. Furthermore, it is also possible to move the object 1 to a place having a different height. In addition, since the noncontact conveying apparatus can be used to keep the object 1 in any orientation, an object oriented horizontally can be changed in its orientation so that the object 1 can be oriented upwardly. Besides, it is further possible to change the orientation of the holding member 3 during the conveyance.

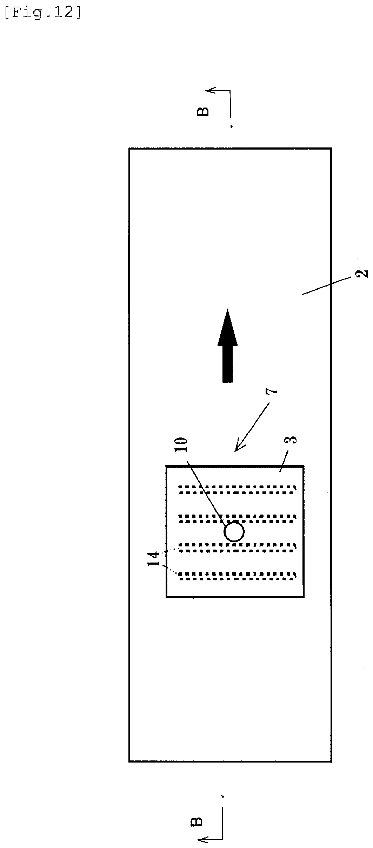

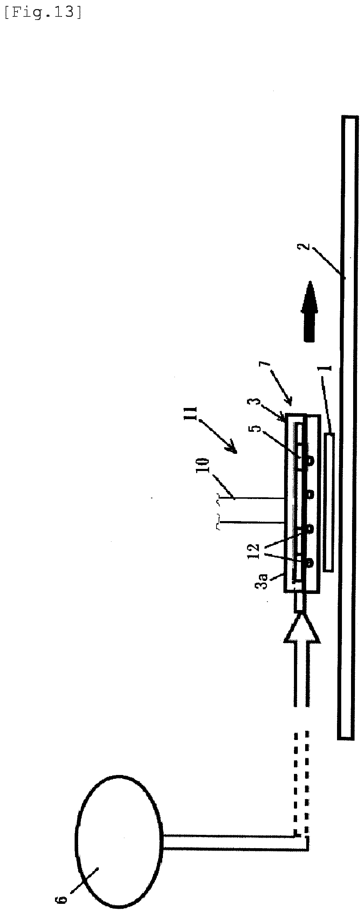

Next, an explanation will be given to describe a noncontact conveying apparatus according to the seventh embodiment of the present invention, with reference to Figs. 12 and 13.

As shown in these figures, in the present embodiment, a plurality of electrostatic chuck electrodes 12 are buried in the holding member 3 instead of using the magnet 9 employed in the sixth embodiment. When these electrostatic chuck electrodes 12 are energized, the object 1 will be attracted towards the holding member 3 by the attracting force generated between the electrostatic chuck electrodes 12 and the object 1. In this way, the electrostatic chuck electrodes 12 can function as an attracting device.

In this embodiment, the magnetic member 8 for the object 1 which was provided in the sixth embodiment is not provided here, while other configurations remain the same as the sixth embodiment.

Further, in this embodiment, since the electrostatic chuck electrodes 12 are used rather than the magnet 9, it is possible for the distance between the object 1 and the surface of the electrostatic chuck electrodes 12 to be set short.

The distance between the surface of the electrostatic chuck electrodes 12 and the surface of the holding member 3 is preferably 0.001 to 5.0 mm, more preferably 0.001 to 3.0 mm, further preferably 0.001 to 2.0 mm. Further, the thickness of the holding member 3 is preferably 2.0 to 25.0 mm, more preferably 2.0 to 20.0 mm, further preferably 2.0 to 10.0 mm.

Next, an explanation will be given to describe a noncontact conveying method using a noncontact conveying apparatus according to the seventh embodiment of the present invention.

First, an object 1 having a predetermined shape (square plate in this example) is placed on a conveying path 2 at a predetermined position.

Next, by moving the moving device 10, the holding member 3 is positioned to face the object 1.

Subsequently, the gas pressurized by the compressor 6 is fed into the pressurizing chamber 4 of the holding member 3, so that this gas is ejected from the surface of the holding member 3 through the pores of the holding member 3, and the electrostatic chuck electrodes 12 are energized to attract the object 1 towards the holding member 3. As a result, the object 1 is held in a noncontact manner on the holding member 3, at a position where a force attracting the object 1 towards the holding member 3 and a force separating the object 1 from the holding member 3 become equal, thereby arriving at an equilibrium.

Next, by moving the moving device 10, the holding member 3 is moved to a predetermined position.

Then, the supply of electricity to the electrostatic chuck electrodes 12 is stopped, and the feeding of gas from the compressor 6 is also stopped, or the gas is withdrawn from the pressurizing chamber 4 to lower the pressure in the pressurizing chamber 4. As a result, the object 1 drops to a predetermined position by virtue of its gravity and is placed thereon.

On the other hand, when the object 1 is not placed on the conveying path 2 but placed in a horizontal orientation or the like, the feeding of the gas into the pressurizing chamber 4 may be continued.

Next, by moving the moving device 10, the holding member 3 can be separated from the object 1.

Next, the holding member 3 will be described. Namely, an explanation will be given to describe how to obtain the holding member 3 having a repulsive force equal to or greater than the gravity of the object 1, regardless of the size of the object 1.

When the object 1 is placed on the holding member 3 where the pressure of the pressurizing chamber 4 (hereinafter, referred to as" internal pressure") is P2, the openings of the pores covered by the article 1 will receive a differential pressure ΔP between an external pressure (atmospheric pressure, or vacuum in some cases) P1 and the internal pressure P2, thereby forming a noncontact relationship between the object 1 and the holding member 3. Namely, the object 1 receives a repulsive force F obtained by multiplying the sum total of the opening areas of all the pores covered with the object 1 by the differential pressure ΔP.

In each of the above-described embodiments, the holding member 3 is made of, for example, porous ceramics, where pores of 0.5 to 10 μm are closely formed together with a porosity η of 20 to 60%. Here, the porosity η means a ratio of sum total opening areas of opening pores per unit area of the surface of the holding member 3, while the pores communicating with the back side of the holding member 3 are formed to have the same density within the plane of the holding member 3. When ceramic sintering technique is used, it is possible to form the holding member 3 of porous ceramics with a porosity η being 20 to 60% and the pore diameter being 0.5 to 10 μm. On the other hand, it is not absolutely necessary to form the holding member 3 using the ceramics, and it is also possible to form the holding member 3 using an organic material such as a polymer, a metal or the like.

Further, when a pressurization is performed using a compressor 6 having a compressor pressure P3 and when an internal pressure of the pressurizing chamber 4 is P2, a flow rate Q can be expressed by the following equation (a).

$$Q = C1 \times (P1 - P2) = C2 \times (P2 - P3) \qquad \cdots\cdots (a)$$

here:

Q: flow rate
C1: Conductance ratio between P1 and P2
C2: Conductance ratio between P2 and P3
P1: external pressure
P2: Internal pressure
P3: Compressor pressure

When the above equation (a) is modified, the following equation (b) can be obtained.

$$\Delta P = (P1 - P2) = (P1 - P3) / (1 + C1/C2) \qquad \cdots\cdots (b)$$

Since C1/C2 in the equation (b) corresponds to a conductance ratio $\beta \times (1 - \alpha)$ of a portion excluding an area ratio $\alpha$ of the object 1 covering the surface of the holding member 3, the following equation (c) can be obtained if the former is replaced with the later.

$$\Delta P = (P1 - P2) = (P1 - P3) / [1 + \beta \times (1 - \alpha)] \qquad \cdots\cdots (c)$$

here:

$\beta = k \times d^2 \times \eta / t$
k: constant
d: pore diameter
$\eta$: porosity
t: thickness of holding member

Here, if a difference between the external pressure P1 and the internal pressure P2 is $\Delta P$, the following equation (d) can be obtained.

$$\Delta P = (P1 - P3) / [1 + \beta (1 - \alpha)] \qquad \cdots\cdots (d)$$

Here, since the object 1 is held in a noncontact manner on the conveying path 2, it is necessary for the differential pressure $\Delta P$ to be larger than a pressure-converted value P1 of the weight of the object 1 being conveyed. Here:

$$PW = (W/S1)$$

PW: Pressure-converted value of the weight of the object being conveyed
W: Weight of the object being conveyed
S1: Area of the object being conveyed

Therefore, the following equation (e) is obtained.

$$\Delta P = (P3 - P1) / [1 + \beta (1 - \alpha)] > PW \qquad \cdots\cdots (e)$$

By changing equation (e), the following equation (f) is obtained.

$$\beta \times (1 - \alpha) < [(P3 - P1) / PW) - 1] \qquad \cdots\cdots \quad (f)$$

By selecting an area ratio $\alpha$ of an object 1 being conveyed which covers the surface of the holding member 3 satisfying the equation (f), and by selecting a holding member 3 having a conductance ratio $\beta$, it is possible for the holding member 3 to have a repulsive force equal to or greater than the gravity of the object 1, regardless of the size of the object 1 being conveyed.

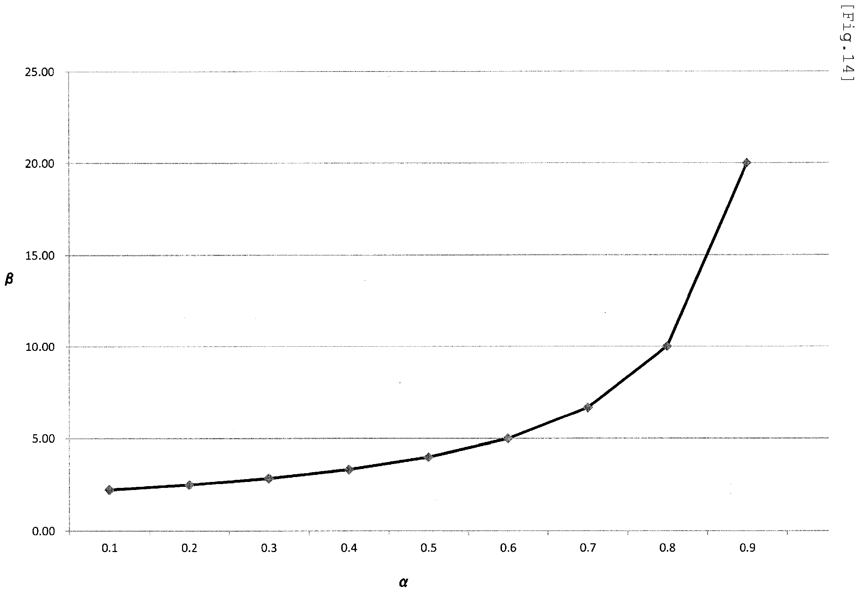

Fig. 14 is a graph showing a relationship between the area ratio $\alpha$ of the object 1 and the conductance ratio $\beta$ of the object 1 (when $\Delta P$ is 0.3 atm) in the present invention.

As shown in the graph, it is impossible to ensure 0.3 atm if the conductance ratio $\beta$ is not increased when the area ratio $\alpha$ of the object 1 covering the surface of the holding member 3 increases.

Example

Table 1 shows the results of carrying out an experiment using the conveying plate 2 of the present invention under the following conditions. In the judgment column of Table 1, ○ was given when the noncontact was favorable, and X was given when it was bad.

<Experiment Conditions>

Shape of the conveying plate: flat plate and cylindrical
Area ratio $\alpha$: 0.0 to 0.656 (-)
Conductance ratio $\beta$: 0.83 to 16680 (-)
Constant k: 0.1491 to 44.48
Pore diameter d: 0.5 to 50 ($\mu$m)
Porosity $\eta$: 25 to 60 (-)
Thickness of the conveying plate t: 2 to 10 (mm)
Area S1 of an object being conveyed: (mm$^2$) S0 $\times$ $\alpha$
Area S0 of the conveying plate: 400 (20 mm $\times$ 20 mm) (mm$^2$) Pressure-converted value PW of the weight of an object being conveyed: 0.1 (atm)
Material of conveying plate: alumina · silica ceramics

[Table 1]

| NO. | $\alpha$ (-) | d ($\mu$m) | $\eta$ (-) | t (mm) | $\beta$ (-) | $(1-\alpha)\times\beta$ (-) | PW (atm) | (P3-P1) | ((P3-P1)/PW)-1 (-) | Judgement | k value (reference) |
|---|---|---|---|---|---|---|---|---|---|---|---|
| 1 | .0.656 | 0.5 | 25 | 2 | 1.39 | 0.478 | 0.1 | 0.987 | 8.87 | ○ | 44.48 |
| 2 | 0.656 | 0.5 | 25 | 2 | 1.39 | 0.478 | 0.1 | 0.592 | 4.92 | ○ | 44.48 |
| 3 | 0.656 | 50 | 30 | 2 | 16680 | 5738 | 0.1 | 0.9 | 8 | × | 44.48 |
| 4 | 0.45 | 0.5 | 25 | 2 | 1.39 | 0.7645 | 0.1 | 0.987 | 8.87 | ○ | 44.48 |
| 5 | 0.45 | 0.5 | 25 | 2 | 1.39 | 0.7645 | 0.1 | 0.592 | 4.92 | ○ | 44.48 |
| 6 | 0.45 | 30 | 25 | 2 | 5004 | 2752 | 0.1 | 0.9 | 8 | × | 44.48 |
| 7 | 0.09 | 0.5 | 25 | 2 | 1.39 | 1.264 | 0.1 | 0.987 | 8.87 | ○ | 44.48 |
| 8 | 0.09 | 0.5 | 25 | 2 | 1.39 | 1.264 | 0.1 | 0.592 | 4.92 | ○ | 44.48 |
| 9 | 0.09 | 20 | 25 | 2 | 2224 | 2024 | 0.1 | 0.592 | 8 | × | 44.48 |
| 10 | 0.837 | 10 | 30 | 2 | 2.237 | 0.364 | 0.1 | 0.296 | 1.96 | ○ | 0.1491 |
| 11 | 0.837 | 30 | 30 | 2 | 20.12 | 6.92 | 0.1 | 0.296 | 1.96 | × | 0.1491 |
| 12 | 0.09 | 10 | 30 | 2 | 2.236 | 2.035 | 0.1 | 0.592 | 4.92 | ○ | 0.1491 |
| 13 | 0.09 | 30 | 30 | 2 | 20.120 | 18.3 | 0.1 | 0.592 | 4.92 | × | 0.1491 |
| 14 | 0.05 | 3.7 | 46 | 2 | 2.179 | 2.07 | 0.1 | 0.839 | 7.39 | ○ | 0692 |
| 15, | 0.5 | 5.2 | 46 | 2 | 4.358 | 2.1789 | 0.1 | 0.839 | 7.39 | ○ | 0.692 |
| 16 | 0.5 | 10 | 46 | 2 | 15.920 | 7.958 | 0.1 | 0.839 | 7.39 | × | 0.692 |
| 17 | 0.5 | 2 | 60 | 2 | 0.830 | 0.4152 | 0.1 | 0.839 | 7.39 | ○ | 0.692 |
| 18 | 0.5 | 20 | 60 | 2 | 83.040 | 41.52 | 0.1 | 0.839 | 7.39 | × | 0.692 |
| 19 | 0.5 | 10 | 60 | 10 | 4.152 | 2.076 | 0.1 | 0.839 | 7.39 | ○ | 0.692 |
| 20 | 0.5 | 2 | 42 | 5 | 4.000 | 2 | 0.1 | 0.9 | 8 | ○ | 11.9 |
| 21 | 0.5 | 5 | 20 | 5 | 11.9 | 5.92 | 0.1 | 0.9 | 8 | ○ | 11.9 |
| 22 | 0.01 | 20 | 40 | 5 | 1423 | 14.23 | 0.1 | 0.9 | 8 | × | 44.48 |
| 23 | 0.01 | 2 | 40 | 5 | 14.23 | 0.1423 | 0.1 | 0.9 | 8 | ○ | 44.48 |

(Note) The above is a study on whether or not it is possible to convey an object as a flat plate of 10 cm×10 cm, while being levitated on a conveying path using a conveying plate of 20 cm × 500 cm.

When selecting an area ratio $\alpha$ of an object 1 being conveyed which covers the surface of the conveying plate 2 satisfying the equation (f) of the present invention, and when selecting a conveying plate 2 having a conductance ratio $\beta$, it is possible for the conveying plate 2 to have a repulsive force equal to or greater than the gravity of the object 1, regardless of the size of the object 1 being conveyed.

As a result, it is possible to convey objects 1 of different sizes in noncontact manner using the same conveying plate 2, thus allowing the same conveying apparatus to convey various objects 1 of different types, thereby increasing the conveying efficiency.

Industrial Applicability

The present invention is suitable for conveying workpieces (objects to be conveyed) of various sizes, can be used in manufacturing apparatuses for making products such as semiconductors, liquid crystals, printed wiring boards and the like, and can also be used in working steps of a printing machine, further can be used in other types of conveyances for preventing scratches from occurring on objects during conveyance.

Explanation of Reference Numerals

1     object being conveyed
2     conveying plate (conveying path)
3     holding member
4     pressurizing chamber
5     pillars
6     compressor (gas delivery means)
7     levitating device
8     magnetic material
9     magnet (attracting device)
10    moving device
11    holding device
12    electrostatic chuck electrodes (attracting device)

**Claims**

1. A noncontact conveying apparatus for conveying an object in a noncontact manner, the conveying apparatus comprising:

   a holding device for holding the object in a noncontact manner; and
   a moving device for moving the holding device; wherein
   the holding device includes: a levitating device for levitating the object being conveyed; and an attracting device for attracting the object;
   the levitating device has : a holding member formed of porous material having a plurality of pores; and gas delivery means for sending gas to the pores of holding member, and ejecting the gas from the pores towards the object being conveyed; and
   the attracting device is attached to the moving device in a manner such that the object is moved by moving the moving device .

2. The noncontact conveying apparatus according to claim 1, wherein the holding member of the levitating device forms a fixed conveying path, the moving device is disposed on a side opposite to the object on the conveying path, and also serves as the attracting device for moving the object while attracting the object.

3. The noncontact conveying apparatus according to claim 1 or 2, wherein the attracting device uses an attracting force of a magnet or electrostatic chuck electrodes.

4. The noncontact conveying apparatus according to claim 2, wherein

   the attracting device uses an attracting force of electrostatic chuck electrodes, the electrostatic chuck electrodes are disposed on a side opposite to the gas ejecting pores on the conveying path, and a plurality of the electrostatic chuck electrodes are arranged at a predetermined interval in a direction intersecting the conveying direction; and the noncontact conveying apparatus further includes a control device, which is so configured that when an object is moved in the conveying direction, the object is moved by controlling a phase shift of a plurality of the electrostatic chuck electrodes and a phase shift of induced electrical charges generated in the object.

5. The noncontact conveying apparatus according to claim 2, wherein

the conveying path is arranged horizontally and linearly; the moving device is disposed at either end in the conveying direction of the conveying path;
the attracting device levitates the object in a noncontact manner by utilizing the gravity of the object and the levitating device; and
the noncontact conveying apparatus further includes a control device, which is so configured that when the object placed at one end of the conveying path is moved towards the other end, the moving device disposed at the one end moves the object until the object reaches a predetermined speed; when the object speed reaches the predetermined speed, one of the moving devices is stopped, the object to be conveyed is moved by an obtained inertial force; and when the object reaches the other end, the other moving device is operated to stop the object.

6. The noncontact conveying apparatus according to claim 1, wherein the holding member is disposed at an angle with respect to a horizontal plane or a vertical plane.

7. A noncontact conveying system using a plurality of noncontact conveying apparatuses according to claim 1 or 2, wherein the conveying path of one noncontact conveying apparatus and the conveying path or the holding member of the other noncontact conveying apparatus, positioned adjacent to each other, are orientated to face one another, and arranged to be partially and mutually overlapped.

[Fig.1]

[Fig. 2]

[Fig. 3]

[Fig. 4]

[Fig. 5]

[Fig.6]

[Fig.7]

[Fig.8]

[Fig.9]

[Fig.10]

EP 3 403 954 A1

[Fig.11]

[Fig.12]

[Fig.13]

EP 3 403 954 A1

[Fig.14]

## INTERNATIONAL SEARCH REPORT

| International application No. |
| --- |
| PCT/JP2017/000955 |

**A. CLASSIFICATION OF SUBJECT MATTER**
*B65G49/07*(2006.01)i, *H01L21/677*(2006.01)i

According to International Patent Classification (IPC) or to both national classification and IPC

**B. FIELDS SEARCHED**

Minimum documentation searched (classification system followed by classification symbols)
B65G49/07, B65G51/00-51/03, B65G54/00-54/02, H01L21/677

Documentation searched other than minimum documentation to the extent that such documents are included in the fields searched
Jitsuyo Shinan Koho          1922-1996    Jitsuyo Shinan Toroku Koho    1996-2017
Kokai Jitsuyo Shinan Koho    1971-2017    Toroku Jitsuyo Shinan Koho    1994-2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 3159137 U  (Soichiro KENMOCHI),<br>13 May 2010 (13.05.2010),<br>paragraphs [0008] to [0013]; fig. 1 to 6<br>(Family: none) | 1-3<br>3-6<br>7 |
| Y | JP 2011-082249 A  (NGK Spark Plug Co., Ltd.),<br>21 April 2011 (21.04.2011),<br>paragraphs [0018] to [0050]; fig. 1 to 6<br>(Family: none) | 3-4 |
| Y | JP 2012-158467 A  (Soichiro KENMOCHI),<br>23 August 2012 (23.08.2012),<br>paragraphs [0007] to [0014]; fig. 1 to 5<br>(Family: none) | 5 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    07 April 2017 (07.04.17) | Date of mailing of the international search report<br>    18 April 2017 (18.04.17) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br><br>Telephone No. |

Form PCT/ISA/210 (second sheet) (January 2015)

**INTERNATIONAL SEARCH REPORT**

International application No.

PCT/JP2017/000955

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2007-182304 A  (Tokyo Electron Ltd.),<br>19 July 2007 (19.07.2007),<br>paragraphs [0015] to [0018]; fig. 1 to 2<br>(Family: none) | 6 |
| A | US 4236851 A  (KASPER INSTRUMENTS, INC.),<br>02 December 1980 (02.12.1980),<br>column 3, line 39 to column 5, line 68; fig. 1<br>to 6<br>(Family: none) | 1-7 |

Form PCT/ISA/210 (continuation of second sheet) (January 2015)

**REFERENCES CITED IN THE DESCRIPTION**

**Patent documents cited in the description**

- JP 2001176950 A
- JP 3159137 B
- JP 5238546 A
- JP 2000025948 A